Europäisches Patentamt

European Patent Office

Office européen des brevets

(11) Veröffentlichungsnummer: **0 048 288**
**B1**

(12) **EUROPÄISCHE PATENTSCHRIFT**

(45) Veröffentlichungstag der Patentschrift: **11.12.85**

(51) Int. Cl.⁴: **H 01 L 21/265**

(21) Anmeldenummer: **80105614.4**

(22) Anmeldetag: **19.09.80**

(54) Verfahren zur Dotierung von Halbleiterbauelementen mittels Ionenimplantation.

(43) Veröffentlichungstag der Anmeldung:
**31.03.82 Patentblatt 82/13**

(45) Bekanntmachung des Hinweises auf die
Patenterteilung:
**11.12.85 Patentblatt 85/50**

(84) Benannte Vertragsstaaten:
**DE FR GB**

(56) Entgegenhaltungen:
**DE-A-2 546 662**

(73) Patentinhaber: **IBM DEUTSCHLAND GMBH**
**Pascalstrasse 100**
**D-7000 Stuttgart 80 (DE)**
(84) **DE**

(73) Patentinhaber: **International Business Machines**
**Corporation**
**Old Orchard Road**
**Armonk, N.Y. 10504 (US)**
(84) **FR GB**

(72) Erfinder: **Hinkel, Holger, Dr.**
**Zeisigweg 13**
**D-7030 Böblingen (DE)**
Erfinder: **Kempf, Jürgen, Dr.**
**Friesenweg 9**
**D-7036 Schönaich (DE)**
Erfinder: **Kraus, Georg**
**Im Heinental 70**
**D-7277 Wildberg 4 (DE)**
Erfinder: **Schmid, Gerhard, Dr.**
**Lindachweg 18**
**D-7021 Stetten/Filder (DE)**

(74) Vertreter: **Kreidler, Eva-Maria, Dr. rer. nat.**
**Schönaicher Strasse 220**
**D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

### Beschreibung

Die Erfindung betrifft ein Verfahren zur Dotierung von Halbleiterbauelementen, bei dem unter Verwendung einer Implantationsmaske mittels Ionenimplantation Fremdionen, die den Leitfähigkeitstyp des Halbleitermaterials bestimmen, in einen Halbleiterkörper eingebracht werden.

Die Ionenimplantation hat eine wesentliche Bedeutung bei der Herstellung von Halbleiterbauelementen und integrierten Schaltkreisen erlangt. Die Ionenimplantation wird vorteilhaft beim Dotieren von Halbleiterkörpern eingesetzt. Sie findet aber auch Anwendung beim Abgleich von integrierten Widerständen, bei der Einstellung von Schwellspannungen von FET's und verschiedenen anderen Aufgaben.

Es ist bekannt, bei der Ionenimplantation zunächst auf den Bereich der Oberfläche des Halbleiterkörpers, in dem die Implantation erfolgen soll, eine Schutzschicht aufzubringen. Man verwendet hierzu im allgemeinen eine Siliciumdioxidschicht in einer Dicke von etwa 10 nm. Die Aufgabe dieser Schutzschicht besteht zum einen darin, eine Richtungssteuerung der auf die Oberfläche des Halbleiterkörpers auftreffenden Ionen zu erreichen und damit zu verhindern, daß diese Ionen entlang bevorzugter kristallographischer Richtungen tief in das Material eindringen. Zum anderen ist das gesamte Halbleitersubstrat während des Eindringens der Dotierungsstoffe durch die Schutzschicht abgedeckt, so daß kein Teil des Substrats zu irgend einem Zeitpunkt den verunreinigenden Einflüssen der Umgebungsatmosphäre ausgesetzt ist. Die Ionen eines verunreinigenden Materials, die sich größtenteils aus Kollisionen zwischen den der Dotierung dienenden Ionen des Ionenstrahls und der Ionenimplantationsvorrichtung, d.h. des Seitenwänden oder -blenden, die den Strahl formen und bilden, ergeben, werden durch die Schutzschicht eingefangen. Unter den Verunreinigungen befinden sich Atome oder Moleküle von Eisen, Nickel, Chrom, Mangan oder Aluminium und auch Öl aus den Vakuumpumpen. In manchen Fällen stammen die Verunreinigungen auch aus den für Masken verwendeten Materialien, beispielsweise Kohlenstoff, der aus Photoresistmaterialien abgegeben wird.

Die Verwendung von Siliciumdioxid als Schutzschicht bietet sich durch seine Verträglichkeit mit den gängigen Halbleiterprozessen an. Bisher wurden Schutzschichten aus Siliciumdioxid hergestellt, indem man die mit der Schutzschicht zu versehenden Bereiche des Siliciumwafers einer trockenen thermischen Oxidation unterwarf. Hierzu wurden die Halbleiterwafer in einen Ofen gebracht und dort während etwa 15 bis 30 Minuten in oxidierender Atmosphäre auf Temperaturen in der Größenordnung von 900°C erhitzt. Während dieser Behandlung bildete sich auf dem Siliciumwafer eine Siliciumdioxidschicht mit einer der Behandlungszeit entsprechenden Schichtdicke.

Es ist auch bekannt (US—A—3 563 809), Implantationsschutzschichten durch direkten Einschuß von Sauerstoffionen in Silicium in Ultrahochvakuum herzustellen. Nachteilig an diesem Verfahren ist jedoch, daß sich Siliciumdioxid erst nach einer relativ langen Implantationszeit von etwa 20 bis 40 Minuten bildet. Dies ist darauf zurückzuführen, daß der gesamte Sauerstoff zunächst in die Kristalltiefe implantiert wird, so daß die Sauerstoffkonzentration an der Siliciumoberfläche klein ist und erst nach einiger Zeit durch Absputtern derselben auf einen konstanten Maximalwert anwächst. Dieser Vorgang führt zu einer verzögerten Sauerstoffanreicherung an der Kristalloberfläche.

Aufgabe der Erfindung ist, ein Verfahren zur Herstellung von Halbleiterbauelementen anzugeben, bei dem eine Implantationsschutzschicht aus Siliciumdioxid schneller als nach dem gegenwärtigen Stand der Technik und unter Einsparung eines zusätzlichen Verfahrensschritts gebildet wird.

Die Aufgabe der Erfindung wird gelöst durch ein Verfahren der eingangs genannten Art, das dadurch gekennzeichnet ist, daß die Implantation der Fremdionen in einer Atmosphäre erhöhten Sauerstoffpartialdrucks vorgenommen wird und während dieser Implantation auf der freiliegenden Oberfläche des Halbleiterkörpers eine Schutzschicht aus Siliciumdioxid in situ gebildet wird.

In vorteilhaften Ausgestaltungen der Erfindung werden Fremdionen wie Bor, Phosphor oder Arsen bei einem Sauerstoffpartialdruck $p \geq 5 \times 10^{-4}$ Pa in den Siliciumwafer implantiert. Bereits im Anfangsstadium der Implantation der zuvor genannten Ionen wird die Schutzschicht aus Siliciumdioxid auf dem Siliciumwafer in situ gebildet.

Das erfindungsgemäße Verfahren ermöglicht, daß ein Verfahrensschritt, nämlich die separate Herstellung der Schutzschicht aus Siliciumdioxid in Wegfall kommen kann, wodurch insgesamt eine Vereinfachung des Verfahrens zur Herstellung integrierter Schaltkreise erreicht wird.

Die Erfindung wird anhand der speziellen Beschreibung und eines in der Zeichnung dargestellten Ausführungsbeispiels näher erläutert.

Es zeigen:

Fign. 1A bis 1D Schnittansichten einer Halbleiteranordnung jeweils nach einzelnen Verfahrensschritten gemäß dem Stand der Technik.

Fign. 2A bis 2D Schnittansichten einer Halbleiteranordnung jeweils nach einzelnen Verfahrensschritten des erfindungsgemäßen Verfahrens, wobei die Fign. 2A und 2D mit den Fign. 1A und 1D identisch sind.

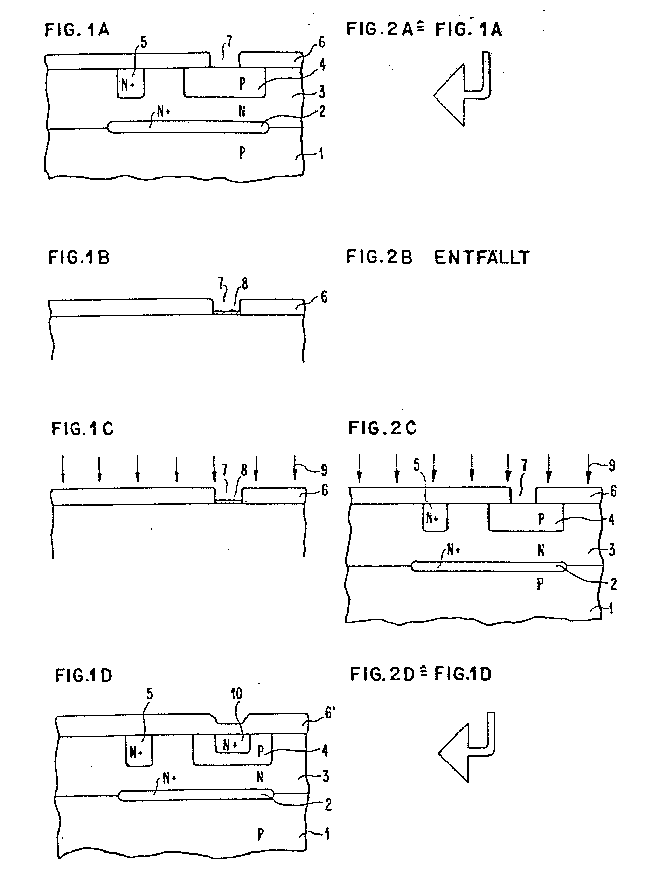

Fig. 1A zeigt einen Halbleiterkörper 1 mit einem Subcollector 2, einem Collector 3, dem Collektoranschluß 5 und des Basis 4 eines Transistors. Auf die Oberfläche dieses Bauelements wird, wie in Fig. 1A gezeigt ist, eine Siliciumdioxidschicht 6 aufgebracht. Dies geschieht durch feuchte thermische Oxidation. In dieser Schicht 6 wird in konventioneller Weise mittels eines photolithographischen Prozesses ein Fenster 7 geöffnet. Die so entstandene Maske dient als Implantationsmaske für die Emitterimplantation in die Basis 4. Gemäß Fig. 1B wird im Bereich des Fensters 7 thermisch eine dünne Siliciumdioxidschicht 8 aufgewachsen, die als Implantationsschutzschicht dient. Es sei bemerkt, daß es sich hier um das Verfahren gemäß dem Stand der Technik handelt.

In Fig. 1C wird die Emitterimplantation von Arsenionen durch die Pfeilen 9 angedeutet. Bei der Implantation wird im Bereich des Fensters 7 die Emitterzone 10 in die Basis 4 des Transistors eingebracht. Hierzu werden $10^{16}$ Arsenionen/cm$^2$ mit einer Energie von 50 KeV im Ultrahochvakuum implantiert. Nach der Arsenionenimplantation wird die Emitter-Eindiffusion vorgenommen. Hierzu wird der Siliciumwafer in einem Ofen in oxidierenden Atmosphäre zwei Stunden lang auf 1000°C erhitzt. Bei diesen Vorgang wird im Bereich des Fensters 7 und der Siliciumdioxidschicht 6 weiteres Siliciumdioxid gebildet (6'). In weiteren Prozeßschritten können in der Schicht 6' Maskenöffnungen erzeugt werden.

Das erfindungsgemäße Verfahren wird anhand der Abbildungen 2A bis 2D gezeigt. Wie ersichtlich ist, kommt der anhand von Fig. 1B dargestellte Schritt des thermischen Aufwachsens einer Schutzschicht 8 aus Siliciumdioxid in Wegfall. Gemäß Fig. 2C wird dagegen die Emitterimplantation der Arsenionen in die blanke Oberfläche des Siliciumsubstrats (Basis 4 des Transistors) und in einer Atmosphäre erhöhten Sauerstoffpartialdrucks vorgenommen. Dann wird gemäß Fig. 2D die Emitter-Eindiffusion vorgenommen, indem der Siliciumwafer in einem Ofen in oxidierender Atmosphäre etwa zwei Stunden lang auf 1000°C erhitzt wird. Hierbei wird im Bereich des Fensters 7 und der Siliciumdioxidschicht 6 weiteres Siliciumdioxid gebildet (6'). In der Siliciumdioxidschicht 6' können in weiteren Prozeßschritten Maskenöffnungen hergestellt werden.

Es wird noch einmal darauf hingewiesen, daß die Emitterimplantation gemäß dem Stand der Technik mit $10^{16}$ Arsenionen pro cm$^2$ und einer Energie von 50 KeV im Ultrahockvakuum vorgenommen wird, während gemäß dem erfindungsgemäßen Verfahren die Emitterimplantation unter sonst gleichen Bedinungen in einer Atmosphäre erhöhten Sauerstoffpartialdrucks mit $p \geqq 5 \times 10^{-4}$ Pa vorgenommen wird.

Das erfindungsgemäße Verfahren kann auch zur Dotierung eines Subcollectors angewendet werden, Hierbei werden Arsenionen mit einer Energie von ca. 40—75 KeV und einer Ionenstromdichte von $7,5 \times 10^{-6}$ A/cm$^2$, was einem Ionenstrom von ca. 0,70 mA bei einer Implantation von Wafern mit einem Durchmesser von 82 mm entspricht, implantiert. Die Implantation erfolgt in die blanke Oberfläche des Siliciumwafers in einer Atmosphäre erhöhten Sauerstoffpartialdrucks ($p \geqq 5 \times 10^{-4}$ Pa). Es wurde festgestellt, daß bei der Implantation der Ionen direkt in das Siliciumsubstrat eine Oxidschutzschicht von etwa 2 nm Dicke in weniger als etwa 10% der Gesamtimplantationszeit gebildet wird.

Nachfolgend wird versucht, eine kurze Deutung der physikalischen Vorgänge der erfindungsgemäßen Verfahrens zu geben. Es ist bekannt, daß durch Beschuß von Halbleitermaterialien mit Ionen die Zahl der Gitterleerstellen erhöht werden kann.

Bei Untersuchungen des Sputterverhaltens von Silicium wurde festgestellt, daß bei Beschuß von Silicium mit Argon unter erhöhtem Sauerstoffpartialdruck eine Oxidation des Siliciums stattfindet. Im Gegensatz zu der bereits eingangs abgehandelten Oxidation durch direkten Einschuß von Sauerstoffionen in das Siliciumsubstrat werden durch den Beschuß mit Argonionen Defekte, bzw. Leerstellen in dem Silicium gebildet, die den an der Siliciumoberfläche adsorptiv festgehaltenen Sauerstoff aufnehmen. Bei diesen Untersuchungen stellte man auch fest, daß die Strahlungsbeschleunigte Diffusion, die nach bisherigen Erkenntnissen nur bei höheren Temperaturen stattfindet, bereits bei Zimmertemperatur einsetzte und bis zu einem gewissen Grad eine Oxidation des Siliciums stattfand. Diese Oxidation—durch Beschuß des Siliciums mit Argonionen unter erhöhtem Sauerstoffpartialdruck—verläuft jedoch verhältnismäßig langsam und dürfte nicht ausreichen, um in genügend kurzer Zeit eine Implantationsschutzschicht aus Siliciumdioxid aufzubauen, deren Funktion es ist, eine Richtungsstreuung auftreffender Ionen zu bewirken und eine Veruneinigung der Oberfläche des Halbleiterkörpers durch zerstäubte Materialien zu verhindern.

Implantiert man dagegen Arsen in einer Atmosphäre erhöhten Sauerstoffpartialdrucks direkt in die Oberfläche von Siliciumwafern dann bildet sich bereits im Anfangsstadium der Implantation mit hinreichender Geschwindigkeit eine Schicht aus Siliciumdioxid auf dem blanken Siliciumwafer in situ. Dies ist wahrscheinlich darauf zurückzuführen, daß wegen der größeren Ionenmasse und der höheren Energie des Arsens eine hohe Anzahl von Leerstellen im Siliciumgitter gebildet wird (vergleiche Ryssel/Ruge "Ionenimplantation", Teubnerverlag Stuttgart, 1978, S. 29, Tabelle 2.3). Außerdem dürfte es eine Rolle spielen, daß bei Arsen, verglichen mit Argon, das Maximum der Leerstellenverteilung, verglichen mit dem Maximum der Ionenverteilung, verhältnismäßig nahe an der Kristalloberfläche liegt. Dadurch ist aber die Lebensdauer der Leerstellen weniger kritisch, so daß während ihrer Lebensdauer eine beschleunigte Diffusion des an der Oberfläche adsorptiv gebundenen Sauerstoffs in die Leerstellen stattfinden kann.

Bei dem erfindungsgemäßen Verfahren kann die Ionenimplantation in üblicher Weise durchgeführt werden. Durch die Tatsache, daß sich durch Implantation bei erhöhtem Sauerstoffpartialdruck bereits in der Anfangsphase der Ionenimplantation eine Siliciumdioxidschutzschicht auf

dem Siliciumwafer ausbildet, kann der Prozeßschritt der thermischen Oxidation zur Herstellung einer Schutzschicht vor der Ionenimplantation eingespart werden, Es entfällt auch, daß die Siliciumwafer zur Oxidation aus der Implantationsvorrichtung speziell in einen Ofen eingebracht und prozessiert werden müssen.

**Patentansprüche**

1. Verfahren zur Dotierung von Halbleiterbauelementen, bei dem unter Verwendung einer Implantationsmaske mittels Ionenimplantation Fremdionen, die den Leitfähigkeitstyp des Halbleiter bestimmen, in einen Halbleiterkörper eingebracht werden, dadurch gekennzeichnet, daß die Implantation der Fremdionen in den Siciliumwafer in einer Atmosphäre erhöhten Sauerstoffpartialdrucks vorgenommen wird und während dieser Implantation auf der freiliegenden Oberfläche des Siliciumwafers eine Schutzschicht aus Siliciumdioxid in situ gebildet wird.

2. Verfahren nach Anspruch 1, dadurch gekennzeichnet, daß die Implantation der Fremdionen bei einem Sauerstoffpartialdruck $p \geqq 10^{-4}$ Pa vorgenommen wird.

3. Verfahren nach den Ansprüchen 1 und 2, dadurch gekennzeichnet, daß als Fremdionen Bor, Phosphor oder Arsen implantiert werden.

4. Verfahren nach den Ansprüchen 1 bis 3, dadurch gekennzeichnet, daß die Siliciumdioxidschutzschicht in einer Schichtdicke von 2 bis 10 nm gebildet wird.

5. Verfahren nach einem oder mehreren der Ansprüche 1 bis 4, dadurch gekennzeichnet, daß zur Dotierung eines Subcollectors $2 \times 10^{16}$ Arsenionen/cm$^2$ mit einer Energie von 40—75 KeV in einer Atmosphäre mit einem Sauerstoff-partialdruck von $5 \times 10^{-4}$ Pa implantiert werden.

6. Verfahren nach einem oder mehreren der Ansprüche 1 bis 4, dadurch gekennzeichnet, daß zur Dotierung eines Emitters $10^{16}$ Arsenionen/cm$^2$ mit einer Energie von 40—75 KeV in einer Atmosphäre mit einem Sauerstoffpartialdruck von $5 \times 10^{-4}$ Pa implantiert werden.

7. Verfahren nach Anspruch 6, dadurch gekennzeichnet, daß die Eindiffusion der implantierten Fremdionen in den Halbleiterkörper in einer oxidierenden Atmosphäre durchgeführt wird.

**Revendications**

1. Procédé pour doper des composants à semiconducteurs, selon lequel, moyennant l'utilisation d'un masque d'implantation on met en place, par implantation ionique, des ions étrangers, qui déterminent le type de conductivité du matériau semiconducteur, dans un corps semiconducteur, caractérisé en ce que l'implantation des ions étrangers dans la pastille de silicium est réalisée dans une atmosphère possédant une pression partielle accrue d'oxygène et que, pendant cette implantation, une couche protectrice de bioxyde de silicium est formée in situ sur la surface libre de la pastille de silicium.

2. Procédé selon la revendication 1, caractérisé en ce que l'implantation des ions étrangers est réalisée avec une pression partielle d'oxygène $p \geqq 10^{-4}$ Pa.

3. Procédé selon les revendications 1 et 2, caractérisé en ce que l'on implante, comme ions étrangers, du bore, du phosphore ou de l'arsenic.

4. Procédé selon les revendications 1 à 3, caractérisé en ce qu'on forme la couche protectrice de bioxyde de silicium avec une épaisseur comprise entre 2 et 10 nm.

5. Procédé selon l'une ou plusieurs des revendications 1 à 4, caractérisé en ce que pour réaliser le dopage d'un sous-collecteur on implante $2 \times 10^{16}$ ions d'arsenic/cm$^2$ avec une énergie de 40—75 keV dans une atmosphère, dans laquelle la pression partielle d'oxygène est de $5 \times 10^{-4}$ Pa.

6. Procédé selon l'une ou plusieurs des revendications 1 à 4, caractérisé en ce que pour réaliser le dopage d'un émetteur, on implante $10^{16}$ ions d'arsenic/cm$^2$ avec une énergie de 40—75 keV dans une atmosphère, dans laquelle la pression partielle d'oxygène est égale à $5 \times 10^{-4}$ Pa.

7. Procédé selon la revendication 6, caractérisé en ce que la diffusion des ions étrangers implantés dans le corps semiconducteur est effectuée dans une atmosphère oxydante.

**Claims**

1. Method for doping semiconductor device structures, wherein, using an implantation mask, doping ions, determining the conductivity type of the semiconductor material, are introduced by means of ion implantation, characterized in that implantation of the doping ions into the silicon wafer is effected in an atmosphere of increased partial pressure of oxygen and during implantation a protective layer of silicon dioxide is formed in situ on the bare surface of the silicon wafer.

2. Method according to claim 1, characterized in that implantation of the doping ions is effected at a partial pressure of oxygen of $\geqq 10^{-4}$ pascal.

3. Method according to claims 1 and 2, characterized in that boron, phosphorus or arsenic are implanted as doping ions.

4. Method according to claims 1 to 3, characterized in that the silicon dioxide protective layer is formed with a thickness of 2 to 10 nm.

5. Method according to any one or several of the claims 1 to 4, characterized in that for doping a subcollector, $2 \times 10^{16}$ arsenic ions/cm$^2$ are implanted at an energy of 40—75 KeV in an atmosphere with a partial pressure of oxygen of $5 \times 10^{-4}$ pascal.

6. Method according to any one or several of the claims 1 to 4, characterized in that for doping an emitter, $10^{16}$ arsenic ions/cm$^2$ are implanted at an energy of 40—75 KeV in an atmosphere with a partial pressure of oxygen of $5 \times 10^{-4}$ pascal.

7. Method according to claim 6, characterized in that diffusion of the implanted doping ions into the semiconductor element is effected in an oxidizing atmosphere.

FIG. 1A

FIG. 2A ≙ FIG. 1A

FIG. 1B

FIG. 2B ENTFÄLLT

FIG. 1C

FIG. 2C

FIG. 1D

FIG. 2D ≙ FIG. 1D